# EUROPEAN PATENT APPLICATION

(11) **EP 3 480 343 A1**
(43) Date of publication of application: **08.05.2019**
(21) Application number: 17199527.7
(22) Date of filing: 01.11.2017
(51) Int. Cl.: C30B 23/00, C30B 29/40, C23C 14/24

(54) **MOLECULAR BEAM EPITAXY SYSTEM AND METHOD FOR REDUCING EXCESS FLUX IN A MOLECULAR BEAM EPITAXY SYSTEM**

(71) Applicant: DCA Cantor Oy, 20630 Turku (FI)
(72) Inventor: DU, Peng, 20900 Turku (FI); SUPPONEN, Esa, 32200 Loimaa (FI)
(74) Representative: Berggren Oy, Turku

(57) **Abstract**

The present invention provides a molecular beam epitaxy system that comprises a growth chamber (101), a substrate manipulator (107) mounted inside the growth chamber (101) for holding a substrate (108) to be epitaxially grown, a source (109, 110) for supplying a flux of a growth material towards the substrate (108), a reflector (113) arranged between the source (109) and the substrate manipulator (107) for reflecting part of the flux supplied by the source (109), and means (115, 201, 202, 203) for collecting at least part of the flux reflected from the reflector (113). The present invention also provides a method for reducing excess flux in a molecular beam epitaxy system.

## Description

### TECHNICAL FIELD OF THE INVENTION

The present invention relates to a molecular beam epitaxy system and a method for reducing excess flux in a molecular beam epitaxy system according to the preambles of the appended independent claims.

### BACKGROUND OF THE INVENTION

Molecular beam epitaxy (MBE) is an epitaxy method for thin-film deposition of single crystals. In MBE, atomic or molecular beams are supplied to a substrate in a high vacuum or ultra-high vacuum environment. The vacuum ensures that the mean free paths of the atoms or molecules are larger than the size of a growth chamber of an MBE system. Another important aspect of MBE is the deposition rate that allows the films to grow epitaxially. The deposition rates in MBE require proportionally better vacuum to achieve the same purity level as other deposition techniques.

A conventional MBE system has a plurality of sources for supplying growth materials to a substrate. In a solid source MBE system, elements such as gallium (Ga) and arsenic (As) are heated in separate effusion cells or electron beam evaporators until they begin to slowly sublime. The gaseous elements then condense on the surface of the substrate, where they may react with each other to form a single-crystal film, such as a GaAs film, on the substrate. Controlling the temperatures of the sources allows controlling the rate of materials impinging on the surface of the substrate.

In known MBE systems, a large part of the growth materials supplied by the sources does not reach the substrate, but instead spreads into a growth chamber of the MBE system. This excess flux of the growth materials forms a residual gas in the growth chamber. This residual gas decreases the quality of the films grown on the substrate, mainly because of the cross contamination of different growth materials in the MBE environment. For example, the background arsenic pressure in a growth chamber during growth of GaAs can be as high as 10⁻⁷ Torr if the arsenic flux for growth is at 10⁻⁵ Torr. This residual gas could be of no harm for a binary compound growth such as GaAs. However, it generates contamination if the growth is carried out for a ternary compound such as InAsP, a quaternary compound such as InAsPSb or a pentanary compound such as InGaAIAsPSb because the incorporation rate of arsenic (As), antimony (Sb) and phosphorus (P) is sensitive to the partial pressure.

A known solution to reduce the excess flux that forms a residual gas in a growth chamber of an MBE system is to use a cryopanel or a pump. A problem of these devices is that they are inefficient in collecting the excess flux, i.e. in lowering the residual gas pressure.

### OBJECTIVES OF THE INVENTION

It is the main objective of the present invention to reduce or even eliminate the prior art problems presented above.

It is an objective of the present invention to provide a molecular beam epitaxy system in which the amount of residual gas formed by the excess flux can be kept at a low level. It is also an objective of the present invention to provide a method for reducing excess flux in a molecular beam epitaxy system to a low level.

In order to realise the above-mentioned objectives, the system and the method according to the invention are characterised by what is presented in the characterising portions of the appended independent claims. Advantageous embodiments of the invention are described in the dependent claims.

### DESCRIPTION OF THE INVENTION

A molecular beam epitaxy system according to the invention comprises a growth chamber, a substrate manipulator mounted inside the growth chamber for holding a substrate to be epitaxially grown, and a source for supplying a flux of a growth material towards the substrate. The molecular beam epitaxy system according to the invention further comprises a reflector arranged between the source and the substrate manipulator for reflecting part of the flux supplied by the source, and means for collecting at least part of the flux reflected from the reflector.

The molecular beam epitaxy (MBE) system according to the invention can be used for the epitaxial growth of thin films on a substrate. For example, thin films of group III-V and II-V, Si/Ge and other semiconductor materials may be epitaxially grown with the MBE system according to the invention. The substrate on which the thin films are deposited can be, for example, a semiconductor substrate, such as a silicon substrate.

The substrate to be epitaxially grown is intended to be attached to the substrate manipulator that is located inside the growth chamber. Before the epitaxial growth, the substrate is typically heated for a certain pre-growth surface treatment such as oxide removal, which produces a clean surface with dangling bonds.

The source is used to supply a flux of a growth material, such as gallium (Ga) or arsenic (As), towards the substrate. The growth material that impinges on the surface of the substrate reacts therein with other growth material(s) and forms a compound, such as GaAs, on the surface of the substrate. The source is attached in connection with the growth chamber that is preferably made of stainless steel. The source can be, for example, an effusion cell, a valved cracker, a plasma source or a gas injector. The effusion cell and the valved cracker incorporate a thermal evaporation process to introduce the atomic or molecular flux into the growth chamber. The effusion cell comprises a crucible for holding the growth material that is heated by a heating element so that the growth material may evaporate. The shape of the crucible determines the flux distribution of the evaporated growth material into the growth chamber. The valved cracker comprises a tank for holding the growth material. From the tank the growth material is passed through a cracking area and then through a nozzle or an injector to be directed into the growth chamber. The flux distribution of the growth material depends on the design of the nozzle or the injector. The plasma source is a source that can provide plasma by DC power, RF power or microwave. The gas injector is typically used to deliver gas against its own pressure.

The source typically comprises a shutter for controlling the flux of the growth material from the source into the growth chamber. The shutter may be computer-controlled allowing precise control of the thickness of each film, down to a single layer of atoms. Controlling the temperature of the source also allows controlling the rate of the growth material impinging on the surface of the substrate.

The growth material is supplied from the source to the substrate in a high vacuum or ultra-high vacuum environment. Because of the vacuum, the mean free paths of the atoms or molecules are larger than the size of the growth chamber. A high vacuum or ultra-high vacuum may be generated and maintained in the growth chamber, for example, by a vacuum pump. If the substrate needs to be cooled, the ultra-high vacuum environment within the growth chamber can be maintained by a system of cryopumps and cryopanels which are chilled using liquid nitrogen or cold nitrogen gas to a temperature close to -196 °C.

The reflector is arranged between the source and the substrate manipulator for reflecting part of the flux supplied by the source. Preferably, the reflector is used to reflect that part of the flux supplied by the source that would not reach the substrate, but instead would spread into the growth chamber. This excess flux of the growth material would form a residual gas in the growth chamber, which residual gas would decrease the quality of films grown on the substrate. The reflector is arranged inside the growth chamber, in front of the source so that part of the flux supplied by the source can be reflected by the surface of the reflector. The collecting means are used to collect at least part of the flux reflected from the reflector. Preferably, the reflector and the collecting means are arranged in such a manner that the flux reflected from the surface of the reflector is directed towards the collecting means.

The MBE system according to the invention may comprise at least one other source for supplying a flux of a growth material. In this case the MBE system comprises a plurality of sources for supplying a flux of a growth material. The MBE system may comprise, for example, two, three, four or more than four sources for supplying a flux of a growth material. The sources are attached in connection with the growth chamber. The sources are preferably arranged to supply different growth materials. Each of the sources may be provided with its own reflector that is arranged between the source and the substrate manipulator for reflecting part of the flux supplied by the source, and with its own means for collecting at least part of the flux reflected from the reflector.

An advantage of the MBE system according to the invention is that the amount of residual gas formed by the excess flux can be kept at a very low level in the growth chamber of the MBE system. Another advantage of the MBE system according to the invention is that it enables the epitaxial growth of high quality films on a substrate.

According to an embodiment of the invention the reflector is provided with an aperture for allowing part of the flux supplied by the source to go through the reflector. The reflector is arranged between the source and the substrate manipulator in such a manner that part of the flux supplied by the source goes through the reflector while another part of the flux is reflected from the surface of the reflector. The reflected flux can then be collected by the collecting means. An advantage of the reflector having an aperture is that it enables to easily modify the distribution of the flux that is directed to the substrate manipulator. The distribution of the flux is determined by the shape of the aperture. The shape of the aperture can be chosen according to the application requirements, for example according to the shape of the substrate. The shape of the aperture can be, for example, circular, oval or rectangular. The size of the aperture can be, for example, 0.01 cm² to 10000 cm².

According to an embodiment of the invention the reflector is planar. An advantage of the planar reflector is that the flux reflected from the surface of the reflector can easily be directed to a desired direction by arranging the reflector in a suitable angle relative to the main direction of the flux supplied by the source. In some applications, the reflector may be curved so that the flux reflected from the surface of the reflector can be focused to a desired area or point from which it can be effectively collected with the collecting means.

According to an embodiment of the invention the reflector is arranged at an angle relative to the main direction of the flux supplied by the source. This enables to direct the flux reflected from the surface of the reflector to a direction away from the source, whereby it is easier to collect the reflected flux with the collecting means. The angle between the reflector and the main direction of the flux supplied by the source can be, for example, 20-70 degrees or 35-55 degrees.

According to an embodiment of the invention the reflector is made of tantalum, molybdenum or titanium. An advantage of making the reflector from these materials is that the reflector is not reactive with the growth material at the working temperature.

According to an embodiment of the invention the means for collecting at least part of the flux reflected from the reflector comprises a pump and/or a cold panel. The pump is a device that can move gas from its entrance. The pump can be arranged in connection with the growth chamber or an auxiliary chamber that is connected to the growth chamber. The cold panel can be a double wall panel that can be filled with water or liquid nitrogen to cool the panel. The cold panel can be, for example, a cryopanel. The cold panel can be mounted inside the growth chamber or an auxiliary chamber that is connected to the growth chamber.

According to an embodiment of the invention the pump is a turbo pump, an ion pump or a cryopump. The turbo pump is a type of a vacuum pump used to obtain and maintain a high vacuum. The turbo pump is a propellant pump with two main components, namely a rotodynamic pump and a driving gas turbine, usually both mounted on the same shaft, or sometimes geared together. The ion pump is a type of a vacuum pump capable of reaching pressures as low as 10 mbar under ideal conditions. The ion pump ionizes gas within the vessel it is attached to and employs a strong electrical potential, typically 3-7 kV, which allows the ions to accelerate into and be captured by a solid electrode and its residue. The cryopump is a vacuum pump that traps gases and vapours by condensing them on a cold surface. The effectiveness depends on the freezing and boiling points of the gas relative to the temperature of the cryopump.

According to an embodiment of the invention the cold panel is made of stainless steel. An advantage of making the cold panel from stainless steel is that the cold panel is water resistant and compatible to a standard vacuum chamber fabrication process.

According to an embodiment of the invention the molecular beam epitaxy system comprises means for cooling the cold panel. The cooling means may comprise a circulation of coolant water or liquid nitrogen. The cold panel may be cooled with liquid nitrogen or cold nitrogen gas to a temperature close to -196 °C.

According to an embodiment of the invention the molecular beam epitaxy system comprises means for heating the reflector. The heating means may comprise, for example, a filament for heating the reflector. Alternatively, the reflector may be heated by the radiation from the source, whereby the temperature of the reflector depends on the temperature of the source and the distance between the source and the reflector. Preferably, the reflector is heated to a temperature of 30 °C to 1000 °C. An advantage of heating the reflector is that the reflector is capable of better reflecting the flux that impinges on the surface of the reflector.

According to an embodiment of the invention the source is an effusion cell, a valved cracker, a plasma source or a gas injector.

The present invention also relates to a method for reducing excess flux in a molecular beam epitaxy system. The method according to the invention comprises supplying with a source a flux of a growth material towards a substrate that is mounted on a substrate manipulator, reflecting part of the flux supplied by the source with a reflector that is arranged between the source and the substrate manipulator, and collecting at least part of the flux reflected from the reflector.

The method according to the invention is used in a molecular beam epitaxy (MBE) system during the epitaxial growth of thin films on a substrate. In the method according to the invention a flux of a growth material is supplied from the source towards the substrate that is attached to the substrate manipulator. The growth material that impinges on the surface of the substrate reacts therein with other growth material(s) and forms a compound on the surface of the substrate. Part of the flux supplied by the source is reflected from the surface of the reflector that is arranged between the source and the substrate manipulator. At least part of this reflected flux is then collected by the collecting means.

An advantage of the method according to the invention is that the excess flux in a growth chamber of an MBE system can be reduced to a very low level. Another advantage of the method according to the invention is that it enables the epitaxial growth of high quality films on a substrate.

According to an embodiment of the invention the method comprises heating the reflector to a temperature of 30 °C to 1000 °C. The reflector may be heated, for example, with a filament. Alternatively, the reflector may be heated by the radiation from the source, whereby the temperature of the reflector depends on the temperature of the source and the distance between the source and the reflector. An advantage of heating the reflector is that the reflector is capable of better reflecting the flux that impinges on the surface of the reflector.

According to an embodiment of the invention the flux reflected from the reflector is collected by using a pump and/or a cold panel.

According to an embodiment of the invention the method comprises cooling the cold panel to a temperature of -250 °C to 20 °C. The cold panel may be cooled, for example, with liquid nitrogen or water.

The exemplary embodiments of the invention presented in this text are not interpreted to pose limitations to the applicability of the appended claims. The verb "to comprise" is used in this text as an open limitation that does not exclude the existence of also unrecited features. The exemplary embodiments presented in this text and their advantages relate by applicable parts to the system as well as the method according to the invention, even though this is not always separately mentioned.

### BRIEF DESCRIPTION OF THE DRAWINGS

- Fig. 1: illustrates a schematic view of a molecular beam epitaxy system according to a first embodiment of the invention,
- fig. 2: illustrates a schematic view of a molecular beam epitaxy system according to a second embodiment of the invention,
- fig. 3: illustrates an exemplary geometry of the flux distribution, and
- figs. 4a-4d: illustrate exemplary reflectors.

### DETAILED DESCRIPTION OF THE DRAWINGS

The same reference signs are used of the same or like components in different embodiments.

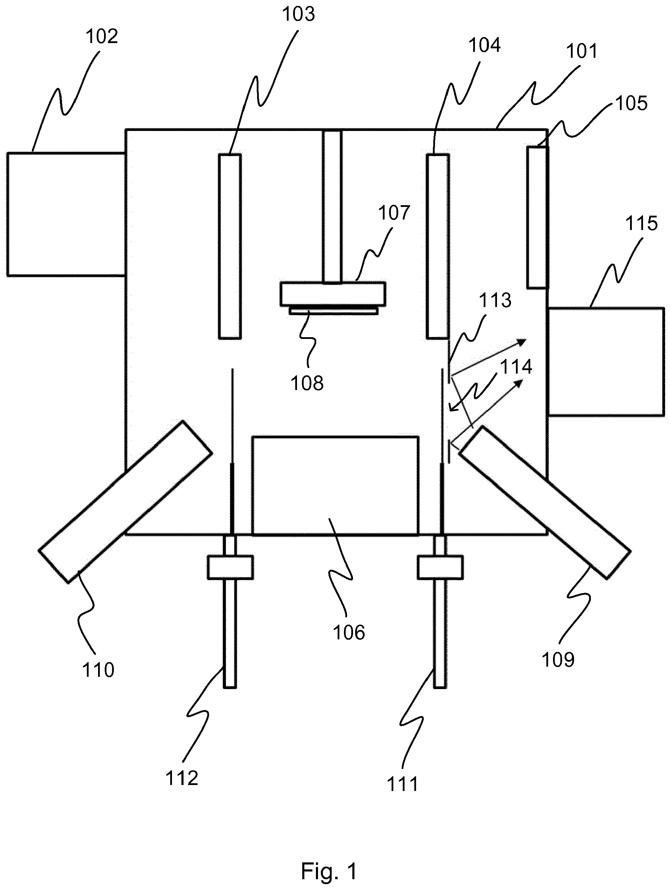

Fig. 1 illustrates a schematic view of a molecular beam epitaxy system according to a first embodiment of the invention. The MBE system comprises a growth chamber 101 that is provided with a vacuum pump 102 and a set of cryopanels 103, 104, 105 and 106 to produce an ultra-high vacuum environment inside the growth chamber 101.

The MBE system comprises a substrate manipulator 107 that is mounted inside the growth chamber 101. The substrate manipulator 107 is used for holding a substrate 108 to be epitaxially grown.

The MBE system comprises sources 109 and 110 for supplying a flux of a growth material towards the substrate 108, and shutters 111 and 112 for controlling the flux of the growth material from the sources 109 and 110 into the growth chamber 101. The source 109 is a cracker that supplies arsenic (As) and the source 110 is an effusion cell that supplies gallium (Ga) towards the substrate 108. The growth materials, i.e. Ga and As that impinge on the substrate 108 form a GaAs layer on the surface of the substrate 108. The rate of the growth materials that impinge on the substrate 108 may be controlled by controlling the temperature of the sources 109 and 110. In order to get a high purity GaAs layer the growth chamber 101 is preferably pumped down to 10⁻¹⁰ Torr. The cryopanels 103, 104, 105 and 106 provide additional pumping capacity, especially when the sources 109 and 110 are hot.

The MBE system comprises a reflector 113 arranged between the source 109 and the substrate manipulator 107 for reflecting part of the flux supplied by the source 109. The reflector 113 is arranged at an angle relative to the main direction of the flux supplied by the source 109 so that the flux reflected from the surface of the reflector 113 is directed to a direction away from the source 109. The reflector 113 and the shutter 111 have an overlap in the view from the source 109 to the substrate 108 so that there is no flux leaking between the shutter 111 and the reflector 113 when the shutter 111 is closed. The reflector 113 is provided with an aperture 114 for allowing part of the flux supplied by the source 109 to go through the reflector 113 to the substrate 108. During the operation of the MBE system, the reflector 113 is heated by the cracking zone of the source 109, which normally has a temperature of 600 °C to 1100 °C.

The MBE system comprises a pump 115 for collecting at least part of the flux reflected from the reflector 113. The pump 115 is arranged relative to the reflector 113 in such a manner that the flux reflected from the surface of the reflector 113 is directed towards the pump 115.

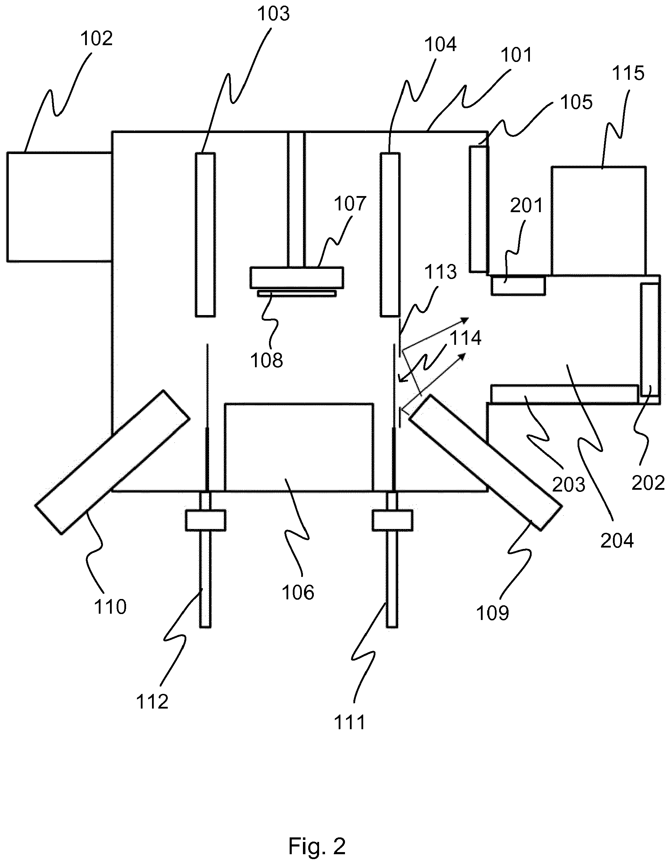

Fig. 2 illustrates a schematic view of a molecular beam epitaxy system according to a second embodiment of the invention. The MBE system of fig. 2 differs from the MBE system of fig. 1 in that the means for collecting at least part of the flux reflected from the reflector 113 also comprises a set of cold panels 201, 202 and 203 that are mounted inside an auxiliary chamber 204 that is connected to the growth chamber 101. Another difference is that in fig. 2 the pump 115 is arranged in connection with the auxiliary chamber 204. During the operation of the MBE system, the cold panels 201, 202 and 203 are cooled with liquid nitrogen, which makes possible a high pumping speed for arsenic (As), phosphorus (P) and antimony (Sb).

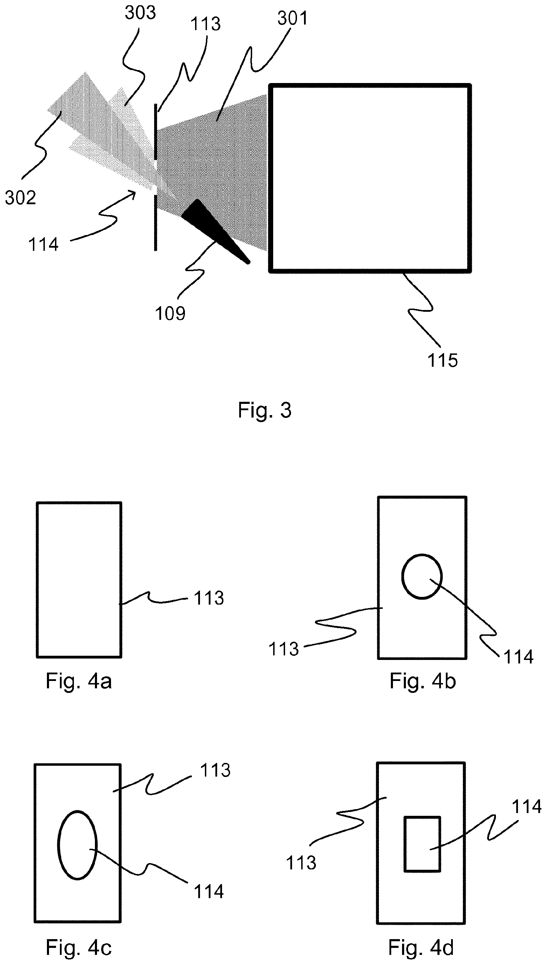

Fig. 3 illustrates an exemplary geometry of the flux distribution. One part (denoted by number 301) of the flux supplied by the source 109 is reflected from the surface of the reflector 113 and directed towards the pump 115 to be collected. The amount of the reflected flux that enters the pump 115 depends on the size of the reflector 113, the distance between the source 109 and the reflector 113, the angle between the reflector 113 and the source 109 and the opening size of the pump 115. Another part of the flux supplied by the source 109 goes through the aperture 114 of the reflector 113. This part of the flux can be divided into a part (denoted by number 302) that impinges on the surface of the substrate (not shown in fig. 3) and a part (denoted by number 303) that misses the substrate.

Figs. 4a-4d illustrate exemplary reflectors. In fig. 4a is shown a reflector 113 that is a rectangular plate. In figs. 4b-4d are shown reflectors 113 having an aperture 114 in the middle of the rectangular plate. In the reflector 113 of fig. 4b, the shape of the aperture 114 is circular. In the reflector 113 of fig. 4c, the shape of the aperture 114 is oval. In the reflector 113 of fig. 4d, the shape of the aperture 114 is rectangular.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A molecular beam epitaxy system, comprising:
- a growth chamber,
- a substrate manipulator mounted inside the growth chamber for holding a substrate to be epitaxially grown, and
- a source for supplying a flux of a growth material towards the substrate,
**characterised in that** the molecular beam epitaxy system comprises:
- a reflector arranged between the source and the substrate manipulator for reflecting part of the flux supplied by the source, and
- means for collecting at least part of the flux reflected from the reflector.

2. The molecular beam epitaxy system according to claim 1, **characterised in that** the reflector is provided with an aperture for allowing part of the flux supplied by the source to go through the reflector.

3. The molecular beam epitaxy system according to claim 1 or 2, **characterised in that** the reflector is planar.

4. The molecular beam epitaxy system according to claim 3, **characterised in that** the reflector is arranged at an angle relative to the main direction of the flux supplied by the source.

5. The molecular beam epitaxy system according to any of the preceding claims, **characterised in that** the reflector is made of tantalum, molybdenum or titanium.

6. The molecular beam epitaxy system according to any of the preceding claims, **characterised in that** the means for collecting at least part of the flux reflected from the reflector comprises a pump and/or a cold panel.

7. The molecular beam epitaxy system according to claim 6, **characterised in that** the pump is a turbo pump, an ion pump or a cryopump.

8. The molecular beam epitaxy system according to claim 6, **characterised in that** the cold panel is made of stainless steel.

9. The molecular beam epitaxy system according to claim 6 or 8, **characterised in that** the molecular beam epitaxy system comprises means for cooling the cold panel.

10. The molecular beam epitaxy system according to any of the preceding claims, **characterised in that** the molecular beam epitaxy system comprises means for heating the reflector.

11. The molecular beam epitaxy system according to any of the preceding claims, **characterised in that** the source is an effusion cell, a valved cracker, a plasma source or a gas injector.

12. A method for reducing excess flux in a molecular beam epitaxy system, comprising:
- supplying with a source a flux of a growth material towards a substrate that is mounted on a substrate manipulator,
**characterised in that** the method comprises:
- reflecting part of the flux supplied by the source with a reflector that is arranged between the source and the substrate manipulator, and
- collecting at least part of the flux reflected from the reflector.

13. The method according to claim 12, **characterised in that** the method comprises heating the reflector to a temperature of 30 °C to 1000 °C.

14. The method according to claim 12 or 13, **characterised in that** the flux reflected from the reflector is collected by using a pump and/or a cold panel.

15. The method according to claim 14, **characterised in that** the method comprises cooling the cold panel to a temperature of -250 °C to 20 °C.
